# DEMANDE DE BREVET EUROPEEN

(11) **EP 1 359 604 A2**
(43) Date de publication de la demande: **05.11.2003**
(21) Numéro de dépôt: 03356070.7
(22) Date de dépôt: 25.04.2003
(51) Int. Cl.: H01L 21/00

(54) **Installation de fabrication de composants semi-conducteurs à faux-plancher ventile**

(30) Priorité: 02.05.2002 FR 0205515
(71) Demandeur: ALCATEL, 75008 Paris (FR)
(72) Inventeur: Bernard, Roland, 74540 Viuz-La-Chiesaz (FR)
(74) Mandataire: Poncet, Jean-François

(57) **Abrégé**

Selon l'invention, une installation de fabrication de composants à semi-conducteur est réalisée dans un bâtiment ayant un étage supérieur (1) et un étage inférieur (6) séparés l'un de l'autre par une dalle de soutien (3) et un faux-plancher (2). La dalle de soutien (3) comporte des ouvertures de passage (8), tandis que le faux-plancher (2) est constitué de plaques ayant elles-mêmes des passages traversants (7). Des moyens de génération de vide (4) sont disposés dans un espace intermédiaire (2c) situé entre la dalle de soutien (3) et le faux-plancher (2) qui lui-même porte une chambre de procédés (1a) située dans l'espace supérieur constituant une salle blanche (1). Des moyens d'aspiration (9) situés dans l'étage inférieur (6) créent un flux gazeux (5) dirigé vers le bas depuis la salle blanche (1) à travers l'espace intermédiaire (2c) vers l'étage inférieur (6). De la sorte, le faux-plancher (2) joue le rôle d'un anti-retour pour les pollutions sonores, thermiques ou chimiques émanant des moyens de génération de vide (4).

## Description

La présente invention concerne les moyens permettant d'intégrer au moins en partie une ligne de pompage à vide dans l'espace intermédiaire situé entre une dalle de soutien et un faux-plancher de salle blanche dans une usine de fabrication de composants semi-conducteurs.

Le sol de la salle blanche d'une usine de fabrication de composants semi-conducteurs est généralement constitué d'un faux-plancher surmontant une dalle de soutien en béton de 90 cm d'épaisseur percée à intervalles réguliers d'ouvertures de passage de 80 cm de long et de 40 cm de large. Les ouvertures de passage sont utilisées pour faire passer les canalisations et câbles vers le sous-sol.

Sur cette dalle de soutien sont fixés, avec un maillage de 60 cm, des pieds vérins de hauteur variable suivant les usines, et sur lesquels reposent des plaques de faux-plancher juxtaposées et perforées en aluminium de 60 × 60 cm. La hauteur des pieds vérins peut varier entre environ 43 cm et environ 120 cm, suivant les usines. Sur les plaques de faux-plancher sont posés les équipements de fabrication des composants semi-conducteurs, notamment les chambres de procédés. Dans le volume sous les plaques de faux-plancher passent les diverses canalisations et câbles nécessaires au fonctionnement des équipements posés sur le faux-plancher constitué par les plaques de faux-plancher.

On a récemment proposé, par exemple dans le document WO 01/82019, d'intégrer, dans l'espace intermédiaire entre la dalle de soutien et le faux-plancher, une partie au moins de la ligne de vide, par exemple un système de pompage à vide constitué d'une pompe primaire avec éventuellement des dispositifs annexes de traitement de gaz pompés.

L'invention vise à profiter des principaux avantages d'une telle intégration au moins partielle du système de pompage à vide dans l'espace entre la dalle et le faux-plancher :
- amélioration de la capacité de pompage utile, par rapprochement de la pompe et des chambres à vide situées dans la salle blanche,
- économie de place dans les sous-sols où sont traditionnellement implantées les pompes à vide,
- économie de ligne de pompage, longue et parfois chauffée depuis le sous-sol jusqu'à la machine.

Mais le rapprochement des moyens de production de vide entraîne des nuisances chimiques et physiques. Ces nuisances sont susceptibles de perturber le fonctionnement des chambres de procédés, dans lesquelles se déroulent des opérations de micro-usinage par plasma gazeux qui sont très sensibles aux perturbations extérieures. Et ces nuisances sont susceptibles de polluer les salles blanches dans lesquelles sont manipulés les produits avant et après micro-usinage.

L'invention vise à éviter les inconvénients des systèmes de l'art antérieur, en permettant en particulier de réduire de façon très sensible les risques de pollution des salles blanches et des chambres de procédés, tout en conservant la proximité des moyens de génération de vide.

Pour cela, l'idée qui est à la base de l'invention est de réaliser un isolement supplémentaire entre les moyens de génération de vide et la salle blanche contenant les chambres de procédés, sas d'entrée et de sortie et chambres de transfert, afin d'éviter à la fois les pollutions vibratoires, les pollutions sonores, les pollutions thermiques, et même les pollutions chimiques et éventuellement électriques.

Pour atteindre ces buts ainsi que d'autres, l'invention prévoit une installation de fabrication de composants à semiconducteur, dans un bâtiment ayant un étage supérieur et un étage inférieur séparés l'un de l'autre par une dalle de soutien ayant une face supérieure et une face inférieure et supportant un faux-plancher formé d'une juxtaposition de plaques de faux-plancher ayant une face supérieure et une face inférieure, avec au moins une chambre de procédés placée dans l'étage supérieur qui constitue en lui-même une salle blanche, et avec des moyens de génération de vide pour générer et entretenir un vide contrôlé dans la chambre de procédés, les moyens de génération de vide étant au moins en partie placés dans un espace intermédiaire situé entre la dalle de soutien et le faux-plancher, les plaques de faux-plancher comportant des passages traversants entre leur face supérieure et leur face inférieure, la dalle de soutien comportant des ouvertures de passage entre sa face supérieure et sa face inférieure ; selon l'invention, des moyens d'aspiration sont prévus dans l'étage inférieur pour aspirer l'atmosphère depuis la salle blanche vers l'étage inférieur, produisant un flux gazeux qui chemine dans les passages traversants des plaques de faux-plancher vers l'espace intermédiaire, autour des moyens de génération de vide dans l'espace intermédiaire, et dans les ouvertures de passage de la dalle de soutien vers l'étage inférieur.

Ainsi, le flux gazeux dans les passages traversants des plaques du faux-plancher s'oppose à la migration rétrograde des éventuelles fuites gazeuses vers la salle blanche, s'oppose à la propagation de chaleur vers la salle blanche, et s'oppose à la propagation des sons vers la salle blanche.

Le faux-plancher joue ainsi le rôle d'un anti-retour pour les pollutions sonores, thermiques ou chimiques émanant des moyens de génération de vide intégrés sous le faux-plancher.

Il est important d'assurer une régularité du flux gazeux autour des moyens de génération de vide. Pour cela, selon un mode de réalisation de l'invention, les moyens de génération de vide sont placés au-dessus d'une ouverture de passage dans la dalle de soutien inférieure.

En alternative, les moyens de génération de vide sont placés au regard d'une zone pleine de la dalle de soutien inférieure, entre des ouvertures de passage.

Dans tous les cas, il est avantageux de faire en sorte que les moyens de génération de vide soient tenus à la fois à l'écart de la face supérieure de la dalle de soutien et à l'écart de la face inférieure des plaques de faux-plancher, afin de laisser une libre circulation de flux gazeux au-dessus et au-dessous des moyens de génération de vide.

Par exemple, les moyens de génération de vide peuvent être supportés par un plateau reposant sur la face supérieure de dalle de soutien par l'intermédiaire de jambes de liaison.

Les jambes de liaison peuvent avantageusement être équipées d'une liaison élastique et amortie, s'opposant à la transmission de vibrations depuis les moyens de génération de vide vers la dalle de soutien et vers le faux-plancher.

Pour s'opposer aux éventuelles pollutions électriques provenant des moyens de génération de vide intégrés sous le faux-plancher, on peut en outre utiliser des plaques de faux-plancher réalisées en un métal conducteur de l'électricité et reliées électriquement à la terre.

Dans ce cas, il est avantageux que les plaques de faux-plancher comprennent une face supérieure recouverte d'une couche superficielle en matière isolante ou semi-isolante. On évite ainsi la prolifération de particules électriquement chargées dans la salle blanche.

D'autres objets, caractéristiques et avantages de la présente invention ressortiront de la description suivante de modes de réalisation particuliers, faite en relation avec les figures jointes, parmi lesquelles:
- la figure 1 illustre schématiquement, en perspective, une usine de fabrication de composants semi-conducteurs selon un mode de réalisation de la présente invention ; et
- la figure 2 est une vue schématique en perspective illustrant un mode de réalisation des moyens de maintien des moyens de génération de vide sous le faux-plancher.

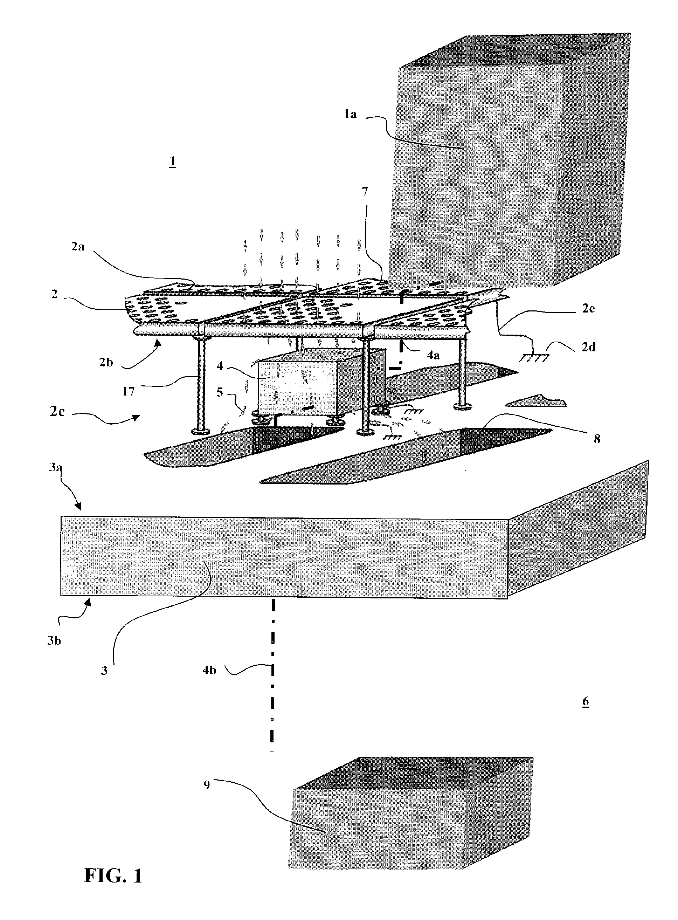

Dans le mode de réalisation illustré sur la figure 1, l'installation de fabrication de composants semi-conducteurs est constituée d'un bâtiment ayant un étage supérieur 1 et un étage inférieur 6 séparés l'un de l'autre par une dalle de soutien 3 et un faux-plancher 2. L'étage supérieur est lui-même une salle blanche, dans laquelle évolue le personnel d'utilisation autour d'au moins une chambre de procédés 1a.

Le faux-plancher 2 est maintenu à l'écart et au-dessus de la dalle de soutien 3, pour constituer un espace intermédiaire 2c.

Une ligne de vide permet de générer et d'entretenir une atmosphère à basse pression à l'intérieur de la chambre de procédés 1a. La ligne de vide comprend des moyens de génération de vide 4 qui sont au moins en partie placés dans l'espace intermédiaire 2c situé entre la dalle de soutien 3 et le faux-plancher 2.

La dalle de soutien 3 est par exemple une dalle de béton, ayant une face supérieure 3a et une face inférieure 3b. La dalle de soutien 3 comporte des ouvertures de passage 8 entre sa face supérieure 3a et sa face inférieure 3b.

Le faux-plancher 2 est constitué d'une juxtaposition de plaques de faux-plancher, par exemple de forme rectangulaire, ayant elles-mêmes une face supérieure 2a et une face inférieure 2b, avec des passages traversants 7 entre la face supérieure 2a et la face inférieure 2b. Les passages traversants 7 peuvent par exemple être des trous de forme circulaire et de diamètre d'environ 2 à 4 cm, régulièrement répartis sur la surface de la plaque de faux-plancher et occupant environ entre le tiers et la moitié de la surface.

Les moyens de génération de vide 4 sont reliés à la chambre de procédés 1a par une canalisation d'aspiration 4a systématiquement illustrée en pointillés sur la figure, et constituée de manière connue.

Selon l'invention, on prévoit dans l'étage inférieur 6 des moyens d'aspiration 9 permettant d'aspirer l'atmosphère depuis la salle blanche 1 vers l'étage inférieur 6, produisant ainsi un flux gazeux 5 qui chemine dans les passages traversants 7 des plaques de faux-plancher 2 vers l'espace intermédiaire 2c, autour des moyens de génération de vide 4 dans l'espace intermédiaire 2c, et dans les ouvertures de passage 8 de la dalle de soutien 3 vers l'étage inférieur 6.

Grâce à la présence des passages traversants 7 de petit diamètre régulièrement répartis sur toute la surface des plaques de faux-plancher 2, le flux gazeux 5 est régulièrement réparti dans l'espace intermédiaire 2c tout autour des moyens de génération de vide 4, et est régulièrement réparti dans la salle blanche 1 autour de la chambre de procédés 1a.

Dans le mode de réalisation illustré sur la figure 1, les moyens de génération de vide 4 sont placés au-dessus d'une zone pleine de la dalle de soutien 3 inférieure, entre plusieurs ouvertures de passage telles que l'ouverture de passage 8. De la sorte, les moyens de génération de vide 4 perturbent le moins possible l'écoulement du flux gazeux 5 par les ouvertures de passage 8, de sorte que le flux gazeux 5 lèche de façon régulière les parois latérales des moyens de génération de vide 4.

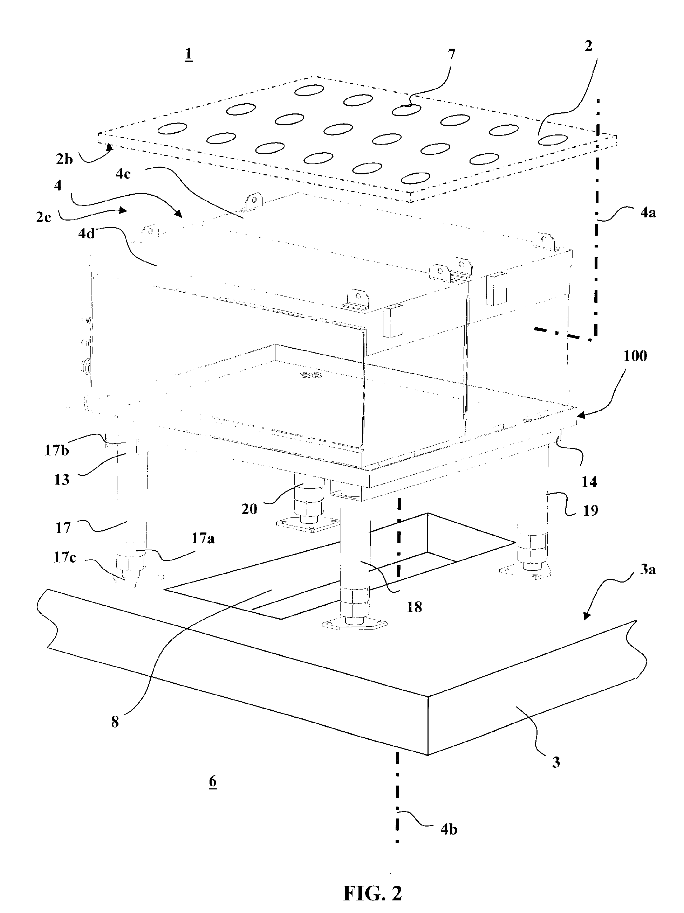

On pourra toutefois préférer le mode de réalisation de la figure 2, dans lequel les moyens de génération de vide 4 sont placés au-dessus d'une ouverture de passage 8 dans la dalle de soutien 3 inférieure. De la sorte, on évite la constitution d'une zone morte au-dessous des moyens de génération de vide 4, zone dans laquelle le flux gazeux est réduit et risque d'entraîner une accumulation de particules polluantes.

Dans ce mode de réalisation de la figure 2, les moyens de génération de vide 4 sont en outre tenus à la fois à l'écart de la face supérieure 3a de la dalle de soutien 3, et à l'écart de la face inférieure 2b des plaques de faux-plancher 2, pour laisser une libre circulation du flux gazeux 5 au-dessus et au-dessous des moyens de génération de vide 4.

Dans ce cas, les moyens de génération de vide 4 sont supportés par un plateau 100 qui repose sur la face supérieure 3a de la dalle de soutien 3 par l'intermédiaire de jambes de liaison 17, 18, 19 et 20. Les jambes de liaison 17-20 comportent de préférence des moyens de réglage en longueur, par exemple des vérins à vis 17a, pour adapter la position verticale du plateau 100 par rapport à la dalle de soutien 3. Chaque jambe de liaison 17-20 comporte une extrémité supérieure ayant un axe vertical 17b engagé dans l'un de plusieurs trous prévus dans des profilés en U 13 ou 14 du plateau 100. Chaque jambe de liaison 17-20 comporte à sa base une plaque de fixation telle que la plaque 17c, que l'on fixe par vissage ou tout autre moyen sur la dalle de soutien 3.

Les jambes de liaison 17-20 peuvent être disposées selon un carré de dimension plus petite que le plateau 100.

La dalle de soutien 3, par exemple en béton de 90 cm d'épaisseur, peut être percée à intervalles réguliers pour constituer les ouvertures de passage 8. Les ouvertures de passage 8 ont par exemple une dimension de 80 cm de long et 40 cm de large, et sont utilisées non seulement pour le passage du flux gazeux 5 mais également pour faire passer les canalisations et câbles entre l'espace intermédiaire 2c et l'étage inférieur 6.

En se référant à nouveau aux modes de réalisation de la figure 1, on distingue que les plaques de faux-plancher 2 sont reliées à la terre 2d par une connexion électrique 2e. Dans ce cas, les plaques de faux-plancher 2 sont en un métal conducteur de l'électricité, afin de constituer une barrière équipotentielle s'opposant à la propagation d'ondes électromagnétiques depuis les moyens de génération de vide 4 vers la salle blanche 1.

Dans ce cas également, les plaques de faux-plancher 2 peuvent avantageusement comprendre une face supérieure 2a recouverte d'une couche superficielle en une matière électriquement isolante ou semi-isolante. On peut par exemple utiliser une couche de polymère, qui évite d'électriser les particules situées dans l'atmosphère de la salle blanche 1.

Les moyens de génération de vide 4 placés dans l'espace intermédiaire 2c peuvent comprendre une ou plusieurs pompes à vide 4c (figure 2) connectées en série, raccordées par la canalisation d'aspiration 4a à au moins une chambre de procédés 1a, et refoulant les gaz pompés par une canalisation de refoulement 4b vers l'atmosphère. Les moyens de génération de vide 4 peuvent comprendre des moyens d'analyse et/ou de traitement des gaz refoulés 4d, placés dans l'espace intermédiaire 2c et/ou dans l'étage inférieur 6.

La présente invention n'est pas limitée aux modes de réalisation qui ont été explicitement décrits, mais elle en inclut les diverses variantes et généralisations qui sont à la portée de l'homme du métier.

## Revendications

1. Installation de fabrication de composants à semiconducteur, dans un bâtiment ayant un étage supérieur (1) et un étage inférieur (6) séparés l'un de l'autre par une dalle de soutien (3) ayant une face supérieure (3a) et une face inférieure (3b) et supportant un faux-plancher formé d'une juxtaposition de plaques de faux-plancher (2) ayant une face supérieure (2a) et une face inférieure (2b), avec au moins une chambre de procédés (1a) placée dans l'étage supérieur qui constitue en lui-même une salle blanche (1), et avec des moyens de génération de vide (4) pour générer et entretenir un vide contrôlé dans la chambre de procédés (1a), les moyens de génération de vide (4) étant au moins en partie placés dans un espace intermédiaire (2c) situé entre la dalle de soutien (3) et le faux-plancher (2), les plaques de faux-plancher (2) comportant des passages traversants (7) entre leur face supérieure (2a) et leur face inférieure (2b), la dalle de soutien (3) comportant des ouvertures de passage (8) entre sa face supérieure (3a) et sa face inférieure (3b), **caractérisée en ce que** des moyens d'aspiration (9) sont prévus dans l'étage inférieur (6) pour aspirer l'atmosphère depuis la salle blanche (1) vers l'étage inférieur (6), produisant un flux gazeux (5) qui chemine dans les passages traversants (7) des plaques de faux-plancher (2) vers l'espace intermédiaire (2c), autour des moyens de génération de vide (4) dans l'espace intermédiaire (2c), et dans les ouvertures de passage (8) de la dalle de soutien (3) vers l'étage inférieur (6).

2. Installation selon la revendication 1, dans laquelle les moyens de génération de vide (4) sont placés au-dessus d'une ouverture de passage (8) dans la dalle de soutien (3) inférieure.

3. Installation selon la revendication 1, dans laquelle les moyens de génération de vide (4) sont placés au-dessus d'une zone pleine de la dalle de soutien (3) inférieure entre des ouvertures de passage (8).

4. Installation selon l'une quelconque des revendications 1 à 3, **caractérisée en ce que** les plaques de faux-plancher (2) sont en un métal conducteur de l'électricité et sont reliées électriquement à la terre (2d).

5. Installation selon la revendication 4, **caractérisée en ce que** les plaques de faux-plancher (2) comprennent une face supérieure (2a) recouverte d'une couche superficielle en une matière électriquement isolante ou semi-isolante.

6. Installation selon l'une quelconque des revendications 1 à 5, **caractérisée en ce que** les moyens de génération de vide (4) sont tenus à la fois à l'écart de la face supérieure (3a) de la dalle de soutien (3) et à l'écart de la face inférieure (2b) des plaques de faux-plancher (2), pour laisser une libre circulation de flux gazeux au-dessus et au-dessous des moyens de génération de vide (4).

7. Installation selon la revendication 6, **caractérisée en ce que** les moyens de génération de vide (4) sont supportés par un plateau (100) reposant sur la face supérieure (3a) de la dalle de soutien (3) par l'intermédiaire de jambes de liaison (17-20).

8. Installation selon la revendication 7, **caractérisée en ce que** les jambes de liaison (17-20) sont équipées d'une liaison élastique et amortie s'opposant à la transmission de vibrations.

9. Installation selon l'une quelconque des revendications 1 à 8, **caractérisée en ce que** les moyens de génération de vide (4) placés dans l'espace intermédiaire (2c) comprennent une ou plusieurs pompes à vide (4c) connectées en série, raccordées par une canalisation d'aspiration (4a) à au moins une chambre de procédés (1a), et refoulant les gaz pompés par une canalisation de refoulement (4b) vers l'atmosphère.

10. Installation selon la revendication 9, **caractérisée en ce que** les moyens de génération de vide (4) comprennent des moyens d'analyse et/ou de traitement des gaz refoulés (4d), placés dans l'espace intermédiaire (2c) et/ou dans l'étage inférieur (6).
